# EUROPEAN PATENT APPLICATION

(11) **EP 3 813 127 A1**
(43) Date of publication of application: **28.04.2021**
(21) Application number: 18923692.0
(22) Date of filing: 27.06.2018
(51) Int. Cl.: H01L 29/78, H01L 29/06, H01L 29/36

(54) **SILICON CARBIDE METAL OXIDE SEMICONDUCTOR FIELD EFFECT TRANSISTOR AND MANUFACTURING METHOD THEREFOR**

(30) Priority: 22.06.2018 CN 201810650037
(71) Applicant: China Electronics Technology Group Corporation No.55 Research Institute, Nanjing, Jiangsu 210016 (CN)
(72) Inventor: YANG, Tongtong, Nanjing, Jiangsu 210016 (CN); BAI, Song, Nanjing, Jiangsu 210016 (CN)
(74) Representative: Sun, Yiming
(86) International application number: PCT/CN2018/093008
(87) International publication number: WO 2019/242036

(57) **Abstract**

The present invention discloses a silicon carbide metal-oxide-semiconductor field-effect transistor and a preparation method therefor. The structure of silicon carbide metal-oxide-semiconductor field-effect transistor comprises: an epitaxial layer, a drain, a first conduction type well region, a second conduction type source region, a first conduction type heavily doped region, a source electrode, a gate oxide layer, a gate electrode, a passivation protection layer and a plurality of first conduction type regions. The introduction of the first conduction type region in the present invention can suppress electric field strength in the gate oxide of a device while increasing the width of Junction Field-Effect Transistor (JFET), thereby increasing the width of the JFET region, reducing the resistance of the JFET region and improving conduction characteristics of the device without influencing device blocking.

## Description

### Technical Field

The present invention relates to a semiconductor and a power semiconductor device and a preparation method therefor, and more particularly to a silicon carbide MOSFET device and a preparation method therefor.

### Background

At present, silicon carbide MOSFET devices have a serious problem in gate oxide reliability. In order to improve device reliability, the electric field strength within the gate oxide of silicon carbide MOSFET devices must be reduced.

In order to improve forward conduction characteristics of silicon carbide MOSFET devices, it is generally desirable to increase the width of a JFET region and decrease the resistance of the JFET region. However, the increase in the JFET width will weaken the capability of adjacent P-wells to suppress the gate oxide electric field, thereby in turn causing a problem in gate oxide reliability.

### Summary

Object of the invention: in order to solve the above problem, the invention provides the structure of a silicon carbide metal-oxide-semiconductor field-effect transistor, which solves the problem that breakdown occurs due to overhigh blocking state of a gate oxide electric field of a device caused by the increase in the JFET width. Another object of the invention is to provide a preparation method for a silicon carbide metal-oxide-semiconductor field-effect transistor.

Technical solution: the present invention provides a silicon carbide metal-oxide-semiconductor field-effect transistor, comprising:
a second conduction type epitaxial layer;
a drain, located on a back surface of the second conduction type epitaxial layer;
a first conduction type well region, adjacent to the second conduction type epitaxial layer and distributed on two sides of the second conduction type epitaxial layer;
a second conduction type source region, located in the first conduction type well region and close to a JFET region;
a first conduction type heavily doped region, located in the first conduction type well region and far away from the JFET region;
a source electrode, located on the second conduction type source region and the first conduction type heavily doped region;
a gate oxide layer, located on the JFET region and a part of the second conduction type source region;
a gate electrode, located on the gate oxide layer;
a passivation protection layer, located on the gate electrode; and
a plurality of first conduction type regions, located within the second conduction type epitaxial layer.

One preferred embodiment of the present invention is that the first conduction type region is doped with a higher concentration than the second conduction type epitaxial layer.

One preferred embodiment of the present invention is that a top of the first conduction type region extends to a lower surface of the gate oxide layer or is at a distance from the gate oxide layer.

One preferred embodiment of the present invention is that a bottom of the first conduction type region extends to or is at a distance from a bottom of the JFET region.

One preferred embodiment of the present invention is that the first conduction type region is located in the JFET region.

One preferred embodiment of the present invention is that the plurality of the first conduction type regions are the same in width.

One preferred embodiment of the present invention is that the plurality of the first conduction type regions are the same in height.

One preferred embodiment of the present invention is that the first conduction type region is uniformly doped or non-uniformly doped.

The invention is suitable for an N-channel MOSFET and a P-channel MOSFET, and further, the first conduction type is an N-type and the second conduction type is a P-type; or the first conduction type is a P-type and the second conduction type is an N-type.

One preferred embodiment of the present invention is that the second conduction type epitaxial layer comprises an N-type heavily doped substrate close to a side of the drain and an N-type lightly doped drift layer far away from the drain.

The present invention provides another silicon carbide metal-oxide-semiconductor field-effect transistor, comprising:
a second conduction type epitaxial layer;
a drain, located on a back surface of the second conduction type epitaxial layer;
a first conduction type well region, adjacent to the second conduction type epitaxial layer and distributed on two sides of the second conduction type epitaxial layer;
a second conduction type source region, located in the first conduction type well region and close to a JFET region;
a first conduction type heavily doped region, located in the first conduction type well region and far away from the JFET region;
a source electrode, located on the second conduction type source region and the first conduction type heavily doped region;
a gate oxide layer, located on the JFET region and a part of the second conduction type source region;
a gate electrode, located on the gate oxide layer;
a passivation protection layer, located on the gate electrode; and
a plurality of first conduction type regions, located within the second conduction type epitaxial layer; a top of at least one of the first conduction type regions being at a distance from a lower surface of the gate oxide layer.

The preparation method for the silicon carbide metal-oxide-semiconductor field-effect transistor comprises following steps: (1) forming an epitaxial layer on a carbonized substrate; (2) preparing a mask medium, preparing an injection mask medium with photoetching, etching and other processes, and preparing a first conduction type well region with an ion injection process; (3) removing the mask medium in step (2), preparing a mask medium again, preparing an injection mask medium with photoetching, etching and other processes, and preparing a second conduction type source region with an ion injection process; (4) removing the mask medium in step (3), preparing a mask medium again, preparing an injection mask medium with photoetching, etching and other processes, and preparing a first conduction type heavily doped region with an ion injection process;(5) removing the mask medium in step (4), preparing a mask medium again, and preparing an injection mask medium with photoetching, etching and other processes; (6) forming a first conduction type region with an ion injection process; (7) removing the mask medium in step (5), and performing sacrificial oxidation and a CMP process on a surface of a device to enable the surface to be smoother; (8) preparing gate oxide with thermal oxidation, and then preparing a gate electrode, the gate electrode being polysilicon or metal; and (9) preparing a source electrode metallization, preparing a passivation protection medium and a drain ohmic metallization, and finishing the preparation of a basic device structure.

Beneficial effects: (1) the present invention can well suppress the electric field strength of the gate oxide of a device, improve the conduction capability of a device while increase the width of JFET by the additional introduction of injection doping region in the JFET region; (2) the present invention is beneficial to making a better compromise between forward conduction characteristics of the device and gate oxide reliability, thereby improving device performance.

### Brief Description of the Drawings

FIG. 1 is a cross-sectional view of a silicon carbide MOSFET device according to Embodiment 1 of the present invention;
FIGs. 2a-l are schematic diagrams of a preparation process for a silicon carbide MOSFET device according to Embodiment 1 of the present invention;
FIG. 3 is a cross-sectional view of a silicon carbide MOSFET device according to Embodiment 2 of the present invention;
FIGs. 4a-l are schematic diagrams of a preparation process for a silicon carbide MOSFET device according to Embodiment 2 of the present invention;
FIG. 5 is a schematic diagram of another preparation process for a silicon carbide MOSFET device according to Embodiment 2 of the present invention;
FIG. 6 is a schematic diagram of the distribution of a first conduction type region 1 formed in a JFET region according to the present invention; and
FIG. 7 is a graph comparing the blocking electric field distribution of a conventional MOSFET device structure and the MOSFET device structure provided by Embodiment 1.

### Detailed Description

The present invention will be further described with reference to the accompanying drawings, wherein the structure is shown as preferred embodiment of the invention, which may, however, be embodied in many different forms and should not be construed as limited to the embodiments set forth herein.

It should be further noted that all directional indications (such as upper, lower, left, right, front, rear) in the embodiments are only used to explain relative position relationship between components, the movement situation thereof, *etc.* in a specific posture (as shown in the drawings), and if the specific posture is changed, the directional indication is changed accordingly.

In the present invention, when the first conduction type is an N-type, the second conduction type is a P-type; when the first conduction type is a P-type, the second conduction type is an N-type.

It should be noted that the preparation processes provided by the embodiments may be modified or adjusted in sequence according to actual situations. Meanwhile, for the convenience of presentation, only an N-channel MOSFET are used for description in the embodiments; the same applies to a P-channel MOSFET.

The second conduction type epitaxial layer described in the embodiments comprises an N-type heavily doped substrate and an N-type lightly doped drift layer, but the N-type heavily doped substrate may not be present.

The width described in the embodiments refers to the length along X-axis direction, and the height or the depth described refers to the length along the Y-axis direction.

The width of the JFET region described in the embodiments refers to the width between adjacent first conduction type well regions.

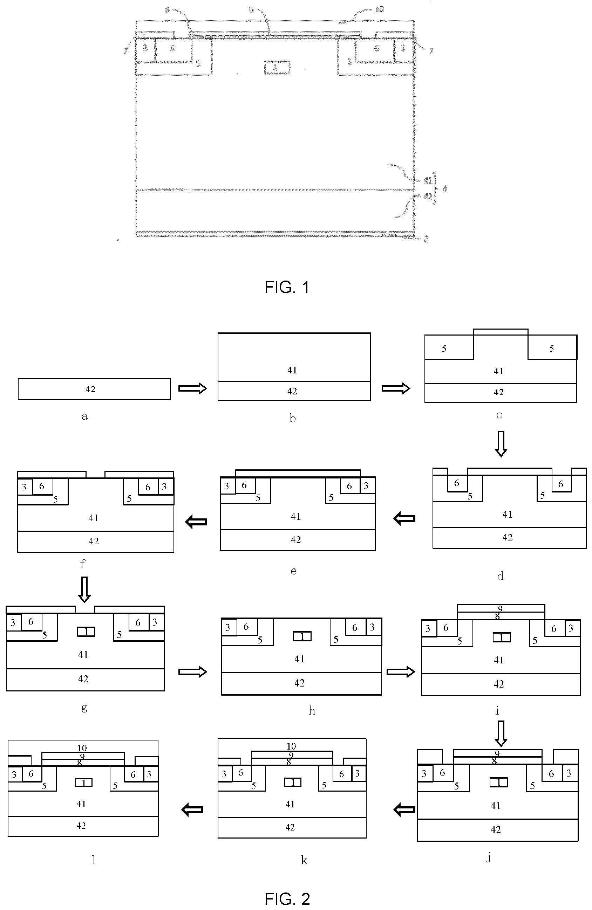

Embodiment 1: the present invention relates to a silicon carbide metal-oxide-semiconductor field-effect transistor, comprising an epitaxial layer 4 and a drain 2 located on the back surface of the epitaxial layer 4; as shown in FIG. 1, the epitaxial layer 4 is composed of an N-type lightly doped drift layer 41 and an N-type heavily doped substrate 42, and the thickness and doping concentration of the N-type lightly doped drift layer 41 can be selected according to the blocking voltage of the device.

The P-well 5 is adjacent to the N-type lightly doped drift layer 41 and distributed on two sides of the N-type lightly doped drift layer 41, and the width between the P wells 5 is the width of the JFET region;

the first conduction type region 1 is located in the JFET region, the first conduction type region 1 is doped with a higher concentration than the N-type lightly doped drift layer 41, a bottom of the first conduction type region 1 is higher than that of the JFET region, a top of the first conduction type region 1 is at a distance from the gate oxide layer 8, and the width of the first conduction type region 1 is smaller than that of the JFET region.

The N⁺ source region 6 is located in the P-well 5 and close to the JFET region; the P⁺ doped region 3 is located in the P-well 5 and far away from the JFET region;
the source electrode 7 is located on the N⁺ source region 6 and the P⁺ doped region 3;
the gate oxide layer 8 is located on the JFET region and a part of the N⁺ source area 6, a gate electrode 9 is located on the gate oxide layer 8, and a passivation protection layer 10 is located on the gate electrode 9.

As shown in FIGs. 2a-l, the preparation method for the structure of Embodiment 1 of the present invention comprises following steps:
(1) as shown in FIG. 2a and FIG. 2b, forming an N-type lightly doped drift layer 41 on an N-type heavily doped substrate 42;
(2) as shown in FIG. 2c, preparing a mask medium, preparing an injection mask medium with photoetching, etching and other processes, and preparing a P-well 5 with an ion injection process;
(3) as shown in FIG. 2d, removing the mask medium in the above step, preparing a mask medium again, preparing an injection mask medium with photoetching, etching and other processes, and preparing an N⁺ source region 6 with an ion injection process;
(4) as shown in FIG. 2e, removing the mask medium in the above step, preparing a mask medium again, preparing an injection mask medium with photoetching, etching and other processes, and preparing a P⁺ doped region 3 with an ion injection process;
(5) as shown in FIG. 2f, removing the mask medium in the above step, preparing a mask medium again, and preparing an injection mask medium with photoetching, etching and other processes;
(6) as shown in FIG. 2g, forming a first conduction type region 1 with an ion injection process;
(7) as shown in FIG. 2h, removing the mask medium in the above step, and performing sacrificial oxidation and a CMP process on a surface of a device to enable the surface to be smoother;
(8) as shown in FIG. 2i, preparing gate oxide layer 8 with thermal oxidation, and then preparing a gate electrode 9; and
(9) as shown in FIGs. 2j, 2k and 2l, preparing a source electrode 7 metallization, preparing a passivation protection medium 10 and a drain 11 electrode ohmic metallization, and finishing the preparation of a basic device structure.

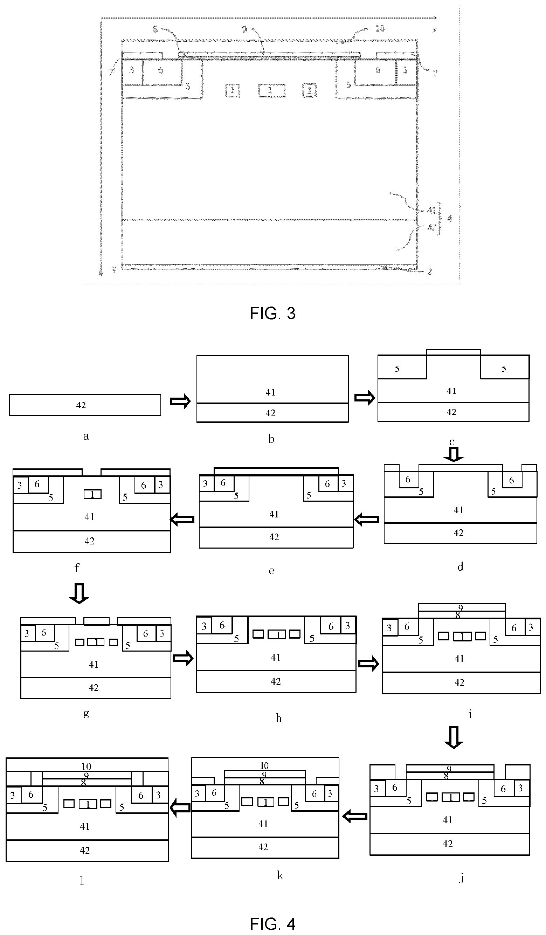

Embodiment 2: another structure of the silicon carbide metal-oxide-semiconductor field-effect transistor described in the present invention is shown in FIG. 3, and is different from the structure in the Embodiment 1 in that three first conduction type regions 1 with the same height are formed in the JFET region by ion injection, and each first conduction type 1 has a different width, the first conduction type region 1 is doped with a higher concentration than the N-type lightly doped drift layer 41, a bottom of the first conduction type region 1 is higher than that of the JFET region, and the tops of the three first conduction type regions 1 extend to a lower surface of the gate oxide layer 8, i.e., the surface of the device.

As shown in FIGs. 4a-l, the preparation method for the structure of Embodiment 2 of the present invention comprises following steps:
(1) as shown in FIG. 4a and FIG. 4b, forming an N-type lightly doped drift layer 41 on an N-type heavily doped substrate 42;
(2) as shown in FIG. 4c, preparing a mask medium, preparing an injection mask medium with photoetching, etching and other processes, and preparing a P-well 5 with an ion injection process;
(3) as shown in FIG. 4d, removing the mask medium in the above step, preparing a mask medium again, preparing an injection mask medium with photoetching, etching and other processes, and preparing an N⁺ source region 6 with an ion injection process;
(4) as shown in FIG. 4e, removing the mask medium in the above step, preparing a mask medium again, preparing an injection mask medium with photoetching, etching and other processes, and preparing a P⁺ doped region 3 with an ion injection process;
(5) as shown in FIG. 4f, removing the mask medium in the above step, preparing a mask medium again, and preparing an injection mask medium with photoetching, etching and other processes;
(6) as shown in FIG. 4g, forming a first conduction type region 1 with an ion injection process;
(7) as shown in FIG. 4h, removing the mask medium in the above step, and performing sacrificial oxidation and a CMP process on a surface of a device to enable the surface to be smoother;
(8) as shown in FIG. 4i, preparing gate oxide layer 8 with thermal oxidation, and then preparing a gate electrode 9; and
(9) as shown in FIGs. 4j, 4k and 4l, preparing a source electrode 7 metallization, preparing a passivation protection medium 10 and a drain 11 electrode ohmic metallization, and finishing the preparation of a basic device structure.

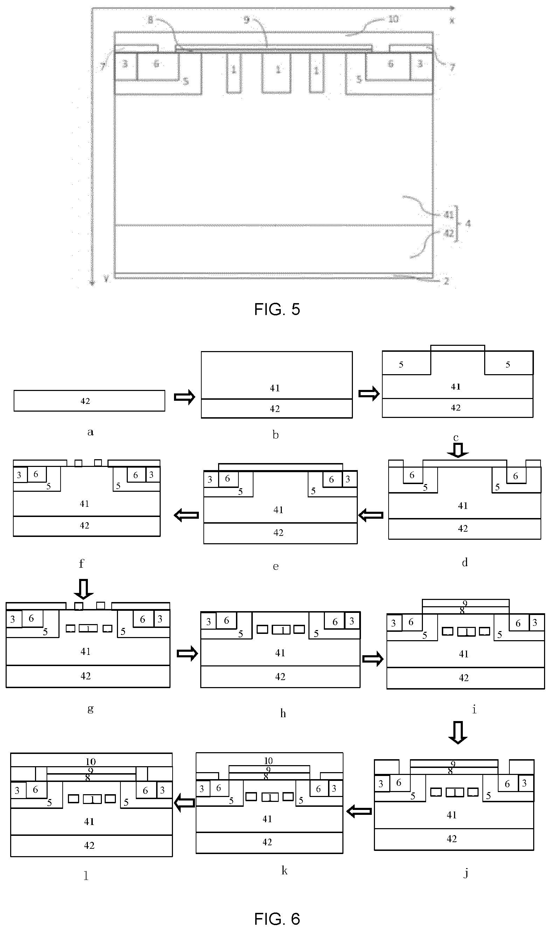

Another preparation method for Embodiment 2 of the present invention is shown in FIGs. 5a-l:
(1) as shown in FIG. 5a and FIG. 5b, forming an N-type lightly doped drift layer 41 on an N-type heavily doped substrate 42;
(2) as shown in FIG. 5c, preparing a mask medium, preparing an injection mask medium with photoetching, etching and other processes, and preparing a P-well 5 with an ion injection process;
(3) As shown in fig. 5d, removing the mask medium in the above step, preparing a mask medium again, preparing an injection mask medium with photoetching, etching and other processes, and preparing an N⁺ source region 6 with an ion injection process;
(4) as shown in FIG. 5e, removing the mask medium in the above step, preparing a mask medium again, preparing an injection mask medium with photoetching, etching and other processes, and preparing a P⁺ doped region 3 with an ion injection process;
(5) as shown in FIG. 5f, removing the mask medium in the above step, preparing a mask medium again, and preparing an injection mask medium with photoetching, etching and other processes;
(6) as shown in FIG. 5g, forming a first conduction type region 1 with an ion injection process;
(7) as shown in FIG. 5h, removing the mask medium in the above step, and performing sacrificial oxidation and a CMP process on a surface of a device to enable the surface to be smoother;
(8) as shown in FIG. 5i, preparing gate oxide layer 8 with thermal oxidation, and then preparing a gate electrode 9; and
(9) as shown in FIGs. 5j, 5k and 5l, preparing a source electrode 7 metallization, preparing a passivation protection medium 10 and a drain 11 electrode ohmic metallization, and finishing the preparation of a basic device structure.

FIG. 6 shows another distribution form of the first conduction type regions 1 of the present invention, when a plurality of first conduction type regions 1 are formed in the JFET region of the present invention by ion injection, the first conduction type regions 1 may be the same or different in width, and adjusted according to the actual electric field distribution; the first conduction type regions 1 may be the same or different in height, and adjusted according to the requirement of actual electric field distribution; the first conduction type regions 1 are doped with a higher concentration than the N-type lightly doped drift layer 41, and a plurality of first conduction type regions 1 may be uniformly doped or non-uniformly doped; the tops of the plurality of first conduction type doped regions 1 may all reach the surface of the device, i.e., below the gate oxide layer 8.

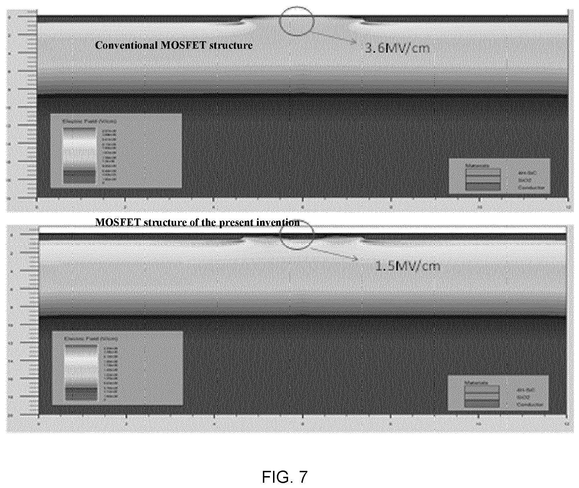

In order to further illustrate the benefits of the present invention on practical devices, FIG. 7 shows simulation results of a conventional MOSFET device structure and the MOSFET device structure provided by Embodiment 1 of the present invention. For 1200V MOSFET device in the simulation, the epitaxial layer has a 10 µm thickness and the epitaxial layer is doped with 1e16cm³. It can be seen from the simulation results that the electric field strength in the gate oxide reaches 3.6 MV/cm for the conventional MOSFET device structure. The electric field strength in the gate oxide is 1.5 MV/cm for the device structure in Embodiment 1 of the present invention. Embodiment 1 of the present invention can obviously reduce the electric field strength of the gate oxide and improve the reliability of the device. The forward conduction characteristics of the device can be improved by adjusting the width of the JFET region or doping of the JFET region, and the overall performance of the device is improved.

## Claims

1. A silicon carbide metal-oxide-semiconductor field-effect transistor, comprising:
a second conduction type epitaxial layer;
a drain, located on a back surface of the second conduction type epitaxial layer;
a first conduction type well region, adjacent to the second conduction type epitaxial layer and distributed on two sides of the second conduction type epitaxial layer;
a second conduction type source region, located in the first conduction type well region and close to a JFET region;
a first conduction type heavily doped region, located in the first conduction type well region and far away from the JFET region;
a source electrode, located on the second conduction type source region and the first conduction type heavily doped region;
a gate oxide layer, located on the JFET region and a part of the second conduction type source region;
a gate electrode, located on the gate oxide layer;
a passivation protection layer, located on the gate electrode; and
a plurality of first conduction type regions, located within the second conduction type epitaxial layer.

2. The silicon carbide metal-oxide-semiconductor field-effect transistor according to claim 1, wherein the first conduction type region is doped with a higher concentration than the second conduction type epitaxial layer.

3. The silicon carbide metal-oxide-semiconductor field-effect transistor according to claim 1, wherein a top of the first conduction type region extends to a lower surface of the gate oxide layer or is at a distance from the gate oxide layer.

4. The silicon carbide metal-oxide-semiconductor field-effect transistor according to claim 1, wherein a bottom of the first conduction type region extends to or is at a distance from a bottom of the JFET region.

5. The silicon carbide metal-oxide-semiconductor field-effect transistor according to claim 1, wherein the first conduction type region is located in the JFET region.

6. The silicon carbide metal-oxide-semiconductor field-effect transistor according to claim 1, wherein the plurality of the first conduction type regions are the same in width.

7. The silicon carbide metal-oxide-semiconductor field-effect transistor according to claim 1, wherein the plurality of the first conduction type regions are the same in height.

8. The silicon carbide metal-oxide-semiconductor field-effect transistor according to claim 1, wherein the first conduction type region is uniformly doped or non-uniformly doped.

9. The silicon carbide metal-oxide-semiconductor field-effect transistor according to claim 1, wherein the first conduction type is an N-type and the second conduction type is a P-type, or the first conduction type is a P-type and the second conduction type is an N-type.

10. The silicon carbide metal-oxide-semiconductor field-effect transistor according to claim 1, wherein the second conduction type epitaxial layer comprises an N-type heavily doped substrate close to a side of the drain and an N-type lightly doped drift layer far away from the drain.

11. A silicon carbide metal-oxide-semiconductor field-effect transistor, comprising:
a second conduction type epitaxial layer;
a drain, located on a back surface of the second conduction type epitaxial layer;
a first conduction type well region, adjacent to the second conduction type epitaxial layer and distributed on two sides of the second conduction type epitaxial layer;
a second conduction type source region, located in the first conduction type well region and close to a JFET region;
a first conduction type heavily doped region, located in the first conduction type well region and far away from the JFET region;
a source electrode, located on the second conduction type source region and the first conduction type heavily doped region;
a gate oxide layer, located on the JFET region and a part of the second conduction type source region;
a gate electrode, located on the gate oxide layer;
a passivation protection layer, located on the gate electrode; and
a plurality of first conduction type regions, located within the second conduction type epitaxial layer; a top of at least one of the first conduction type regions being at a distance from a lower surface of the gate oxide layer.

12. A preparation method for a silicon carbide metal-oxide-semiconductor field-effect transistor, comprising following steps:
(1) forming an epitaxial layer on a carbonized substrate;
(2) preparing a mask medium, preparing an injection mask medium with photoetching, etching and other processes, and preparing a first conduction type well region with an ion injection process;
(3) removing the mask medium in step (2), preparing a mask medium again, preparing an injection mask medium with photoetching, etching and other processes, and preparing a second conduction type source region with an ion injection process;
(4) removing the mask medium in step (3), preparing a mask medium again, preparing an injection mask medium with photoetching, etching and other processes, and preparing a first conduction type heavily doped region with an ion injection process;
(5) removing the mask medium in step (4), preparing a mask medium again, and preparing an injection mask medium with photoetching, etching and other processes;
(6) forming a first conduction type region with an ion injection process;
(7) removing the mask medium in step (5), and performing sacrificial oxidation and a chemical mechanical polishing (CMP) process on a surface of a device to enable the surface to be smoother;
(8) preparing gate oxide with thermal oxidation, and then preparing a gate electrode, the gate electrode being polysilicon or metal; and
(9) preparing a source electrode metallization, preparing a passivation protection medium and a drain ohmic metallization, and finishing the preparation of a basic device structure.
